(19) Europäisches Patentamt
European Patent Office
Office européen des brevets

(11) **EP 4 036 949 B1**

(12) **EUROPEAN PATENT SPECIFICATION**

(45) Date of publication and mention
of the grant of the patent:
**21.05.2025 Bulletin 2025/21**

(21) Application number: **22153050.4**

(22) Date of filing: **24.01.2022**

(51) International Patent Classification (IPC):
***H01H 33/59*** *(2006.01)* ***H01H 9/54*** *(2006.01)*

(52) Cooperative Patent Classification (CPC):
**H01H 33/596;** H01H 2009/543

(54) **A HYBRID DC CIRCUIT BREAKER**

HYBRIDER GLEICHSTROMSCHUTZSCHALTER

DISJONCTEUR À COURANT CONTINU HYBRIDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2021 CN 202110123898**
**29.01.2021 CN 202120268285 U**

(43) Date of publication of application:
**03.08.2022 Bulletin 2022/31**

(73) Proprietor: **Eaton Electrical Ltd.**
**Suzhou (CN)**

(72) Inventor: **LEUSENKAMP, Martin Bernardus Johannes**
**Suzhou, 215121 (CN)**

(74) Representative: **Schwan Schorer & Partner mbB**
**Patentanwälte**
**Bauerstraße 22**
**80796 München (DE)**

(56) References cited:
**JP-A- 2001 067 969     JP-A- 2003 123 599**
**JP-A- 2005 044 591     JP-A- 2014 235 834**
**JP-A- 2015 115 096**

## Description

## TECHNICAL FIELD

The present invention relates to the field of circuit breakers, and in particular to a hybrid DC circuit breaker.

## BACKGROUND

A DC power supply system lacks a voltage zero crossing point, so that it is difficult to cut off a fault current in the DC power supply system. In order to quickly cut off a fault current and to enable a mechanical switch to switch off without causing any arc, a hybrid DC circuit breaker is currently provided. The hybrid DC circuit breaker includes a mechanical switch and a semiconductor switch and a surge arrester (also referred to as a lightning protector, a surge protector, or a surge protection device) connected in parallel to the mechanical switch.

Basic principles of the hybrid DC circuit breaker are as follows: when a fault current (such as a short-circuit current) occurs in a DC circuit, the mechanical switch is triggered to switch off. In a process of switching off of the mechanical switch, in order to prevent the mechanical switch in the process of switching off from producing an arc, the semiconductor switch is controlled to be on first, so that a current is diverted to the semiconductor switch. Then, the mechanical switch is switched off. After the mechanical switch is switched off, the semiconductor switch is then switched off, thereby completing a fast cutting-off process of a short-circuit current. The surge arrester is used to absorb residue electric energy in the DC power supply system.

However, an existing hybrid DC circuit breaker cannot ensure that switching off of the mechanical switch is completely arc-free, and it cannot be determined when to switch on the semiconductor switch so as to cause the mechanical switch to safely and reliably cut off a fault current.

In JP 2001 067969 A there is disclosed a hybrid DC circuit breaker as it is defined in the pre-characterizing portion of claim 1.

## SUMMARY

With respect to the aforementioned technical problems in the prior art, the present invention provides a hybrid DC circuit breaker, comprising:

a mechanical switch connected on a first current branch; and
a semiconductor switch and a forced resonance injection circuit connected on a second current branch, the forced resonance injection circuit comprising a first terminal and a second terminal, the first terminal of the forced resonance injection circuit being connected to one end of the semiconductor switch, and the second terminal of the forced resonance injection circuit and the other end of the semiconductor switch being connected to two ends of the mechanical switch;
wherein the hybrid DC circuit breaker is configured such that it possible to control the semiconductor switch to be on, when the mechanical switch is in a process of switching off, and at the same time to control the forced resonance injection circuit to inject to the mechanical switch a gradually increasing injection current in a direction opposite to that of a current in the mechanical switch, so that the current in the mechanical switch gradually decreases to zero within a predetermined diverting time, and the current is diverted from the first current branch to the second current branch.

In accordance with the present invention, the forced resonance injection circuit comprises: a DC power source, powered by a DC voltage on the first current branch or an external power source, so as to charge a DC bus capacitor; a DC bus, connected to the DC bus capacitor, and used to provide a current to the forced resonance injection circuit; an inverter, provided with switching pulses during current injection so as to produce periodic square-wave voltage pulses having alternating polarities; a resonance circuit, comprising an inductor and a capacitor connected in series to each other, having one end connected to an output end of the inverter, and having the other end used to output an alternating current having gradually increasing amplitude; a rectifying circuit, having an input end connected to the other end of the resonance circuit, and having an output end used to output a pulsating direct current having gradually increasing amplitude, and an output module, having an input end electrically connected to the output end of the rectifying circuit, and having an output end used as the first terminal and the second terminal of the forced resonance injection circuit, the output module being used to filter and amplify the pulsating direct current, and output the injection current; wherein an equivalent resistor, an equivalent inductor, and an equivalent capacitor of the inverter, the resonance circuit, the rectifying circuit and the output module form an underdamped resonance circuit
and a frequency of the periodic square-wave voltage pulses depends on a resonance frequency of the underdamped resonance circuit.

Preferably, the hybrid DC circuit breaker is configured such that it possible to control the forced resonance injection circuit to stop outputting the injection current, when the current in the mechanical switch decreases to zero within the predetermined diverting time.

Preferably, the hybrid DC circuit breaker is configured such that it possible to control the semiconductor switch to be off, when a contact pitch of the mechanical switch reaches a predetermined threshold.

Preferably, the semiconductor switch is a bidirectionally controllable semiconductor switch; wherein the hybrid DC circuit breaker further comprises a polarity module connected between the rectifying circuit and the output module, and the polarity module comprises a full-bridge circuit controlled to change polarities of an input current and an output current of the polarity module, wherein the equivalent resistor, the equivalent capacitor, and the equivalent inductor of the inverter, the resonance circuit, the rectifying circuit, the polarity module and the output module form the underdamped resonance circuit.

Preferably, the inverter is a single-level, two-level, or multi-level full-bridge inverter or half-bridge inverter.

Preferably, the output module is configured to produce a current disconnection between the input end thereof and the first current branch.

Preferably, the output module is an autotransformer comprising a first winding and a second winding, a first terminal of the first winding being electrically connected to a first output terminal of the rectifying circuit, a second terminal of the first winding being electrically connected to a first terminal of the second winding, and being used as a first output terminal of the forced resonance injection circuit, and a second terminal of the second winding being electrically connected to a second output terminal of the rectifying circuit, and being used as a second output terminal of the forced resonance injection circuit.

Preferably, the transformer or the autotransformer is coreless.

Preferably, the polarity module comprises: a first switching transistor and a second switching transistor connected to form a first bridge arm, a first node formed by connecting the first switching transistor and the second switching transistor to each other being used as the first polarity terminal; and a third switching transistor and a fourth switching transistor connected to form a second bridge arm, a second node formed by connecting the third switching transistor and the fourth switching transistor to each other being used as the second polarity terminal; wherein a first electrode of the first switching transistor and a first electrode of the third switching transistor are connected to a positive polarity output terminal of the rectifying circuit, and a second electrode of the second switching transistor and a second electrode of the fourth switching transistor are connected to a negative polarity output terminal of the rectifying circuit.

Preferably, the hybrid DC circuit breaker further comprises a surge arrester connected in parallel to the semiconductor switch.

When a DC power supply system supplies power normally, power consumption of the forced resonance injection circuit of the present invention is zero. When a fault current occurs in the DC power supply system, the forced resonance injection circuit controllably injects to the mechanical switch a gradually increasing injection current having an opposite direction, so that a current diverting time can be controlled, and a recovery voltage between the two ends of the mechanical switch is low, thereby enabling the mechanical switch to safely and reliably cut off the fault current.

## BRIEF DESCRIPTION OF THE DRAWINGS

Embodiments of the present invention are further described below with reference to the accompanying drawings:

FIG. 1 is a block diagram of a hybrid DC circuit breaker according to a preferred embodiment of the present invention;

FIG. 2 is an oscillogram of currents in the hybrid DC circuit breaker shown in FIG. 1;

FIG. 3 shows a specific block diagram of a forced resonance injection circuit in the hybrid DC circuit breaker shown in FIG. 1;

FIG. 4 is an oscillogram of a resonance current outputted by a resonance circuit in the forced resonance injection circuit shown in FIG. 3;

FIG. 5 is an oscillogram of a rectified current outputted by a rectifying circuit in the forced resonance injection circuit shown in FIG. 3;

FIG. 6 is an oscillogram of an injection current outputted by an output module in the forced resonance injection circuit shown in FIG. 3;

FIG. 7 is a specific circuit diagram of a hybrid DC circuit breaker according to a first embodiment of the present invention;

FIG. 8 is a specific circuit diagram of a polarity module in a hybrid DC circuit breaker according to a second embodiment of the present invention;

FIG. 9 is a specific circuit diagram of an output module in a hybrid DC circuit breaker according to a third embodiment of the present invention;

FIG. 10 is a specific circuit diagram of a semiconductor switch in a hybrid DC circuit breaker according to a fourth embodiment of the present invention; and

FIG. 11 is a specific circuit diagram of an inverter in a hybrid DC circuit breaker according to a fifth embodiment of the present invention.

## DETAILED DESCRIPTION OF THE EMBODIMENTS

In order to make the objectives, technical solutions and advantages of the present invention clearer, the present invention is further described in detail below through specific embodiments with reference to the accompanying drawings.

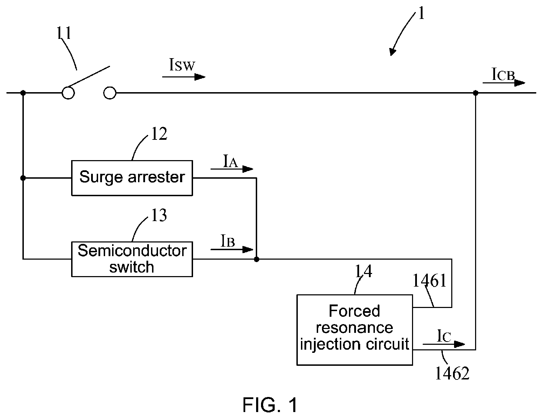

FIG. 1 is a block diagram of a hybrid DC circuit breaker according to a preferred embodiment of the present invention. As shown in FIG. 1, the hybrid DC circuit breaker 1 includes a mechanical switch 11 connected on a first current branch and a semiconductor switch 13 and a forced resonance injection circuit 14 connected on a second current branch. The forced resonance injection circuit 14 includes a terminal 1461 and a terminal 1462. The terminal 1461 of the forced resonance injection circuit 14 is connected to one end of the semiconductor switch 13. The other end of the semiconductor switch 13 and the terminal 1462 of the forced resonance injection circuit 14 are connected to two ends of the mechanical switch 11. The hybrid DC circuit breaker 1 further includes a surge arrester 12 connected in parallel to the semiconductor switch 13.

For ease of following description, directions of a current $I_{SW}$ in the mechanical switch 11, a current $I_A$ in the surge arrester 12, a current $I_B$ in the semiconductor switch 13, an injection current Ic outputted by the forced resonance injection circuit 14, and a current $I_{CB}$ in the hybrid DC circuit breaker 1 are respectively indicated by arrows in FIG. 1.

The forced resonance injection circuit 14 is controlled to output the gradually increasing injection current Ic. The injection current Ic flows into the mechanical switch 11, has a direction opposite to a direction of the current $I_{SW}$ in the mechanical switch 11, and is used to cause the current $I_{SW}$ in the mechanical switch 11 to gradually decrease to zero within a predetermined diverting time.

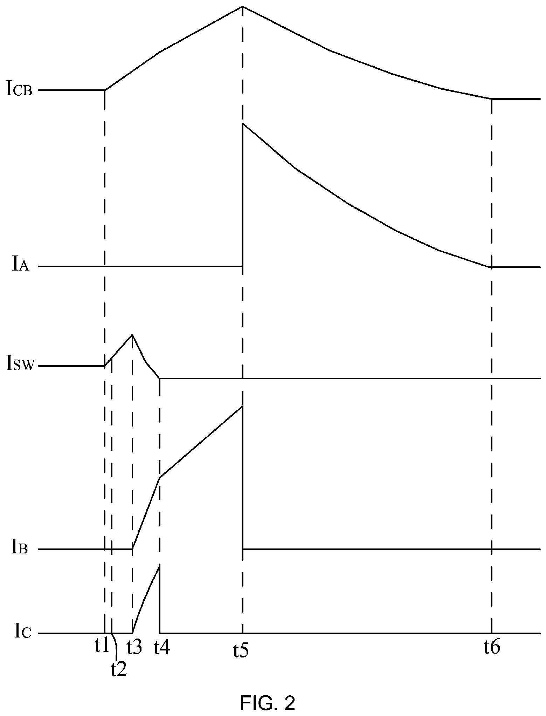

FIG. 2 is an oscillogram of currents in the hybrid DC circuit breaker shown in FIG. 1. As shown in FIG. 2, prior to a time point t1, a DC power supply system is in a normal power supply state. No fault current is present in a circuit. The mechanical switch 11 is in an on state, and the semiconductor switch 13 is in an off state. The DC power supply system supplies power to a load (not shown in FIG. 1) normally by means of the mechanical switch 11 that is on. In this case, the current $I_A$ in the surge arrester 12, the current $I_B$ in the semiconductor switch 13, and the injection current Ic outputted by the forced resonance injection circuit 14 are all zero, and the current $I_{SW}$ in the mechanical switch 11 is equal to the current $I_{CB}$ in the hybrid DC circuit breaker 1. Because the current in the forced resonance injection circuit 14 is zero, power loss of the forced resonance injection circuit 14 is zero during normal power supply.

At the time point t1, when the load is shorted, the current $I_{SW}$ in the mechanical switch 11 increases sharply, and the current $I_{CB}$ in the hybrid DC circuit breaker 1 increases sharply.

At a time point t2, when the current $I_{SW}$ in the mechanical switch 11 increases to be a tripping current, a control device or a trip circuit (not shown in FIG. 1) starts to control the mechanical switch 11 to switch off.

From the time point t2 to a time point t3, contacts of the mechanical switch 11 are in a separation process. The current $I_{SW}$ in the mechanical switch 11 increases gradually. The current $I_{CB}$ in the hybrid DC circuit breaker 1 increases gradually.

At the time point t3, the semiconductor switch 13 is controlled to be on, and at the same time the forced resonance injection circuit 14 is controlled to start outputting the injection current Ic at the time point t3. The injection current Ic flows from the terminal 1461 to the terminal 1462, and is injected into the mechanical switch 11 in a direction opposite to the direction of the current $I_{SW}$ in the mechanical switch 11.

From the time point t3 to a time point t4, the injection current Ic outputted by the forced resonance injection circuit 14 increases gradually, and the current $I_B$ in the semiconductor switch 13 increases gradually. The direction of the injection current Ic is opposite to the direction of the current $I_{SW}$ in the mechanical switch 11, so that the current $I_{SW}$ in the mechanical switch 11 decreases gradually. In this process, the current $I_{SW}$ in the mechanical switch 11 is gradually diverted into the semiconductor switch 13, and the current $I_B$ in the semiconductor switch 13 and the current $I_{CB}$ in the hybrid DC circuit breaker 1 continue increasing.

At the time point t4, the current $I_{SW}$ in the mechanical switch 11 is zero. In this case, a current diverting process is completed. The injection current Ic outputted by the forced resonance injection circuit 14 is equal to zero. Current injection into the mechanical switch 11 is stopped.

From the time point t4 to a time point t5, a short-circuit current flows through only the semiconductor switch 13 in the on state. In this case, the current $I_B$ in the semiconductor switch 13 continues increasing, and the current $I_{CB}$ in the hybrid DC circuit breaker 1 increases gradually. In this process, a moving contact of the mechanical switch 11 continues opening at a speed of a few meters per second, and a distance between the moving contact and a static contact reaches a predetermined contact pitch at the time point t5. The injection current Ic outputted by the forced resonance injection circuit 14 has caused the current $I_{SW}$ in the mechanical switch 11 to be diverted into the semiconductor switch 13, so that in this process the mechanical switch 11 does not withstand a great current interruption, and that is, does not need to switch off at a large current. Specifically, the mechanical switch 11 can switch off at zero current, and can switch off without causing any arc.

At the time point t5, the control device (not shown in FIG. 1) controls the semiconductor switch 13 to be in an off state or a switched-off state, and the current $I_B$ in the semiconductor switch 13 decreases to zero. In this case, the current $I_{CB}$ in the hybrid DC circuit breaker 1 is maximized.

From the time point t5 to a time point t6, a potential zero crossing point is not present in the DC power supply system, so that in this case residual electric energy in the DC power supply system is discharged by means of the surge arrester 12 and the terminals 1461 and 1462 of the forced resonance injection circuit 14, and the surge arrester 12 starts consuming the electric energy in the DC power supply system. Therefore, the current $I_A$ in the surge arrester 12 gradually decreases to zero, and at the same time the current $I_{CB}$ in the hybrid DC circuit breaker 1 gradually decreases to zero. Eventually at the time point t6, a fault is cleared.

In the hybrid DC circuit breaker 1 of the present invention, the two terminals 1461 and 1462 of the forced resonance injection circuit 14 and the semiconductor switch 13 are connected in series on the second current branch, and are not connected on the first current branch on which the mechanical switch 11 is located, so that in a normal power supply or DC transmission process, the DC power supply system supplies power to a load by means of only the mechanical switch 11, and power consumption of the forced resonance injection circuit 14 is zero.

In addition, in a process of switching off of the mechanical switch 11, the forced resonance injection circuit 14 of the present invention can controllably inject to the mechanical switch 11 the gradually increasing injection current Ic opposite to the current $I_{SW}$, and the current $I_{SW}$ in the mechanical switch 11 can be controlled to be diverted to the semiconductor switch 13 from the time point t3 to the time point t4. That is, a current diverting time can be controlled.

The forced resonance injection circuit 14 can control a current change rate of the current $I_B$ in the semiconductor switch 13 at the ending time point t4 of current diverting. A small current change rate enables the mechanical switch 11 to switch off fast and to have small switching-off loss. At the ending time point t4 of current diverting (namely the time point t4), a recovery voltage between the two ends of the mechanical switch 11 depends on resistance of the semiconductor switch 13 and the current $I_B$ in the semiconductor switch 13, and the recovery voltage between the two ends of the mechanical switch 11 can be low, such as a few volts to tens of volts. At the ending time point of current diverting, the mechanical switch 11 has a small current change rate, and the recovery voltage between the two ends of the mechanical switch 11 is low, so that the mechanical switch 11 can switch off safely and reliably.

A time period from the time point t4 to the time point t5 is a turn-off delay time of the hybrid DC circuit breaker 1, and is used to cause the distance between the moving contact and the static contact of the mechanical switch 11 to reach the predetermined contact pitch within the turn-off delay time. The predetermined contact pitch and the turn-off delay time depend on the recovery voltage of the mechanical switch 11 and an opening speed of the moving contact.

When the hybrid DC circuit breaker 1 is used in a bidirectional DC power supply system, for example when the direction of the current in the hybrid DC circuit breaker 1 is opposite to the direction of the current $I_{CB}$, the forced resonance injection circuit 14 is controlled to output the gradually increasing injection current to the terminal 1461 thereof.

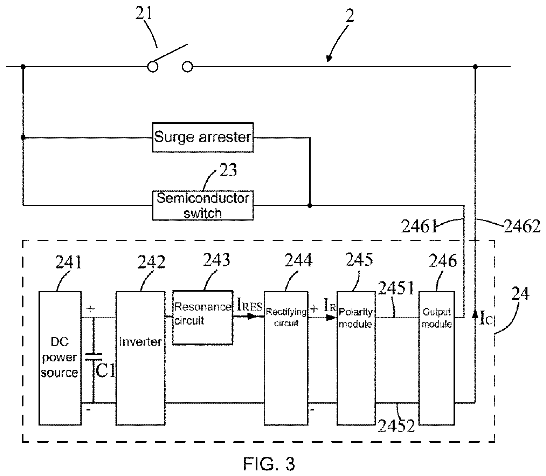

FIG. 3 shows a specific block diagram of a forced resonance injection circuit in the hybrid DC circuit breaker shown in FIG. 1. As shown in FIG. 3, the forced resonance injection circuit 24 includes a DC power source 241, and a DC bus capacitor C1, an inverter 242, a resonance circuit 243, a rectifying circuit 244, a polarity module 245, and an output module 246 connected between DC buses. An input end of the inverter 242 is connected to the DC power source 241. An output end of the inverter 242 is connected to an input end of the rectifying circuit 244 by means of the resonance circuit 243. An output end of the rectifying circuit 244 is connected to an input end of the polarity module 245. An output end of the polarity module 245 is connected to an input end of the output module 246. One terminal 2461 of the output module 246 is connected to an end of the semiconductor switch 23, and the other terminal 2462 is connected to an end of the mechanical switch 21.

The DC power source 241 is powered by a DC voltage on the first current branch or an external power source, so as to charge the DC bus capacitor C1. The DC bus capacitor C1 provides a current to the forced resonance injection circuit by means of the DC bus.

An equivalent resistor, an equivalent capacitor, and an equivalent inductor of the inverter 242, the resonance circuit 243, the rectifying circuit 244, the polarity module 245, and the output module 246 form an underdamped resonance circuit.

The control device (not shown in FIG. 3) provides a high-frequency (such as 10 to 100 kHz) pulse width modulated signal, namely switching pulses, to the inverter 242, so that the inverter 242 inverts a direct current on the DC bus capacitor C1 into an alternating current, namely periodic square-wave voltage pulses having alternating polarities, a frequency of the periodic square-wave voltage pulses depending on a resonance frequency of the underdamped resonance circuit, so that the resonance circuit 243 outputs a resonance current $I_{RES}$.

The output module 246 is further configured to produce a current disconnection between the input end thereof and the first current branch.

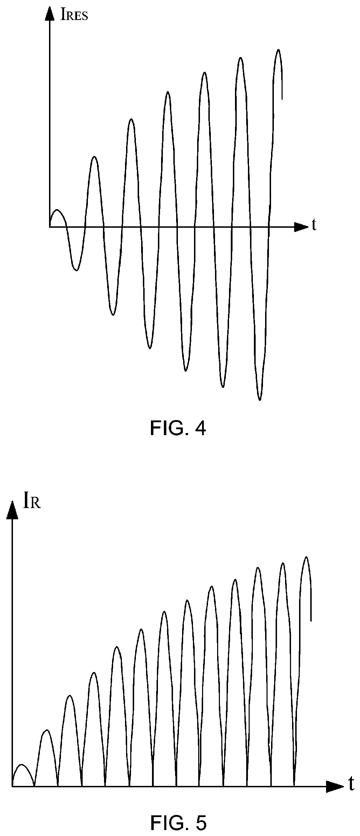

FIG. 4 is an oscillogram of a resonance current outputted by a resonance circuit in the forced resonance injection circuit shown in FIG. 3. As shown in FIG. 4, the resonance current $I_{RES}$ is an alternating current having gradually increasing amplitude, and a resonance frequency thereof depends on an inherent frequency of an inductor, a capacitor, and an equivalent resistor (such as a bulk resistor of the inductor and the capacitor) of an equivalent load circuit. At the beginning of oscillation, the inverter 242 outputs a voltage to the resonance circuit 243, and therefore the resonance circuit 243 starts producing an oscillating current. Each time the resonance current $I_{RES}$ crosses a zero point, the inverter 242 is controlled to switch an output voltage polarity, and electric energy on the DC bus capacitor C1 is outputted to the resonance circuit 243 by means of the inverter 242, so as to provide electric energy within each switching period, so that the amplitude of the resonance current $I_{RES}$ outputted by the resonance circuit 243 increases gradually.

The rectifying circuit 244 is used to rectify the resonance current $I_{RES}$ outputted by the resonance circuit 243 into a pulsating direct current.

FIG. 5 is an oscillogram of a rectified current outputted by a rectifying circuit in the forced resonance injection circuit shown in FIG. 3. As shown in FIG. 5, the rectified current $I_R$ is a pulsating direct current having a constant current direction and periodically increasing amplitude.

The polarity module 245 includes a positive polarity input terminal, a negative polarity input terminal, a polarity terminal 2451, and a polarity terminal 2452. The positive polarity input terminal and the negative polarity input terminal of the polarity module 245 are respectively connected to a positive polarity output terminal and a negative polarity output terminal of the rectifying circuit 244. The polarity module 245 controllably causes the polarity terminals 2451 and 2452 thereof to be a positive polarity output terminal and a negative polarity output terminal, or causes the polarity terminals 2451 and 2452 thereof to be a negative polarity output terminal and a positive polarity output terminal. Therefore, the polarity module 245 outputs a pulsating direct current having a phase being the same as or reverse to that of the pulsating direct current outputted by the rectifying circuit 244.

The output module 246 is used to filter out or reduce an AC component in the pulsating direct current outputted by the polarity module 245, so as to output a smooth direct current having gradually increasing amplitude.

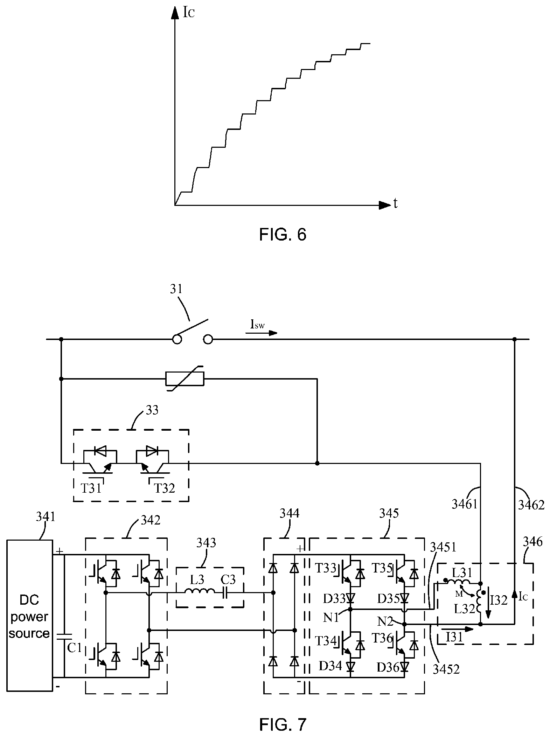

FIG. 6 is an oscillogram of an injection current outputted by an output module in the forced resonance injection circuit shown in FIG. 3. As shown in FIG. 6, the injection current Ic outputted by the output module 246 is a smooth direct current, and amplitude thereof increases gradually over time. The injection current Ic is outputted from the terminal 2462 of the output module 246, and flows into the mechanical switch 21, so that the current in the mechanical switch 21 decreases gradually to zero within the current diverting time.

The high-frequency (such as 10 to 100 kHz) pulse width modulated signal is provided to the inverter 242, so that the output module 246 can output a gradually increasing smooth direct current within a few periods of a switching frequency (for example, within tens to hundreds of microseconds), and therefore a fault current in the mechanical switch 21 can be quickly diverted into the semiconductor switch 23.

In other embodiments of the present invention, when the hybrid DC circuit breaker 2 is used in a unidirectional DC power supply system, the hybrid DC circuit breaker 2 may not have the polarity module 245, and the semiconductor switch 23 may be a unidirectionally controllable semiconductor switch.

FIG. 7 is a specific circuit diagram of a hybrid DC circuit breaker according to a first embodiment of the present invention. As shown in FIG. 7, the semiconductor switch 33 is a bidirectionally controllable switch, and includes an insulated-gate bipolar transistor T31 having an antiparallel diode and an insulated-gate bipolar transistor T32 having an antiparallel diode. An emitter of the insulated-gate bipolar transistor T31 is connected to an emitter of the insulated-gate bipolar transistor T32. Unidirectional conduction of a direct current is achieved by controlling the insulated-gate bipolar transistor T31 or T32 to be on.

An inverter 342 is a full-bridge inverter consists of four field effect transistors.

A resonance circuit 343 includes an inductor L3 and a capacitor C3 connected in series to each other. By selecting the inductor L3 and the capacitor C3 having suitable parameters, when $R' < 2\sqrt{L'/C'}$, an underdamped resonance circuit is formed. R', L', and C' are respectively an equivalent resistance value, an equivalent inductance value, and an equivalent capacitance value of the inverter 342, the resonance circuit 343, a rectifying circuit 344, a polarity module 345, and an output module 346. For example, when the equivalent resistance value, the equivalent inductance value, and the equivalent capacitance value are respectively 3.5 ohm, 150 µH, and 82 nF, an underdamped resonance circuit is formed.

A switching frequency of the inverter 342 depends on a resonance frequency of the underdamped resonance circuit. For example, when the inductor L3 of 150 µH and the capacitor C3 of 82 nF are selected, the switching frequency of the inverter 342 is $1/2\pi\sqrt{L'/C'}$, that is, about 45 kHz.

When two diagonal insulated-gate bipolar transistors in the inverter 342 are controlled to be on, a DC power source 341 outputs electric energy by means of the two diagonal insulated-gate bipolar transistors that are on, so that the resonance circuit 343 outputs a current of a first polarity. When the other two diagonal insulated-gate bipolar transistors in the inverter 342 are controlled to be on, the DC power source 341 outputs electric energy by means of the two diagonal insulated-gate bipolar transistors that are on, so that the resonance circuit 343 outputs a current of a second polarity having increased amplitude. The insulated-gate bipolar transistors in the inverter 342 are controlled to be alternately on in the aforementioned two manners, so that the resonance circuit 343 outputs, within a plurality of switching periods of a pulse width modulated signal, an alternating current having gradually increasing amplitude.

The rectifying circuit 344 is a full-wave rectifying circuit, and includes four diodes.

The polarity module 345 includes a full-bridge circuit controlled to change polarities of an input current and an output current of the polarity module. Specifically, the polarity module 345 includes four insulated-gate bipolar transistors T33, T34, T35, and T36 having antiparallel diodes, and diodes D33, D34, D35, and D36 respectively connected in series to the insulated-gate bipolar transistors T33, T34, T35, and T36. The insulated-gate bipolar transistor T33 and the diode D33 connected in series to each other and the insulated-gate bipolar transistor T34 the diode D34 connected in series to each other are connected to each other to form a node N1 used as a polarity terminal 3451 of the polarity module 345, and the insulated-gate bipolar transistor T35 and the diode D35 connected in series to each other and the insulated-gate bipolar transistor T36 the diode D36 connected in series to each other are connected to each other to form a node N2 used as a polarity terminal 3452 of the polarity module 345. When the diagonal insulated-gate bipolar transistors T33 and T36 are controlled to be on, the polarity terminals 3451 and 3452 are respectively used as a positive polarity output terminal and a negative polarity output terminal of the polarity module 345. When the diagonal insulated-gate bipolar transistors T34 and T35 are controlled to be on, the polarity terminals 3451 and 3452 are respectively used as a negative polarity output terminal and a positive polarity output terminal of the polarity module 345.

The output module 346 is an autotransformer, and the autotransformer is coreless to prevent magnetic saturation. The autotransformer includes a winding L31 and a winding L32. A dotted terminal of the winding L31 is connected to the node N1. A dotted terminal of the winding L32 and an opposite-polarity terminal of the winding L31 are connected to each other, and are used as a terminal 3461 of the output module 346. An opposite-polarity terminal of the winding L32 is connected to the node N2, and is used as a terminal 3462 of the output module 346.

When the polarity terminal 3452 of the polarity module 345 outputs a current I31, and the current I31 flows into the opposite-polarity terminal of the winding L32, the current I31 flows from the opposite-polarity terminal of the winding L31 to the dotted terminal thereof. A current I32 is present from the dotted terminal of the winding L32 to the opposite-polarity terminal thereof. The terminal 3462 outputs an injection current Ic. The injection current Ic is equal to the sum of the current I31 and the current I32. The injection current Ic is injected into a mechanical switch 31, so that a current $I_{SW}$ in the mechanical switch 31 decreases gradually to zero within a predetermined current diverting time.

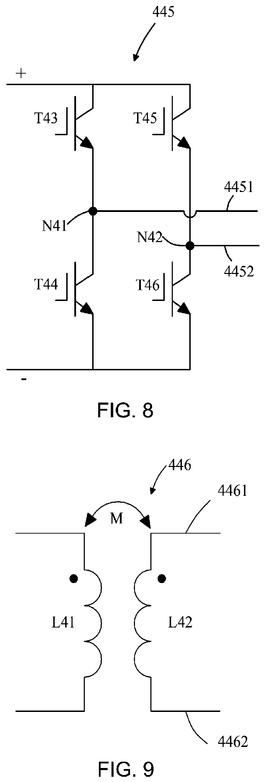

FIG. 8 is a specific circuit diagram of a polarity module in a hybrid DC circuit breaker according to a second embodiment of the present invention. As shown in FIG. 8, a polarity module 445 includes four insulated-gate bipolar transistors T43, T44, T45, and T46 having no antiparallel diode. The insulated-gate bipolar transistors T43 and T44 are connected to form a bridge arm, and the insulated-gate bipolar transistors T45 and T46 are connected to form another bridge arm. Specifically, collectors of the insulated-gate bipolar transistors T43 and T45 are connected to each other, and are used to be connected to a positive polarity output terminal of a rectifying circuit. Emitters of the insulated-gate bipolar transistors T44 and T46 are connected to each other, and are used to be connected to a negative polarity output terminal of the rectifying circuit. A node N41 formed by connecting an emitter of the insulated-gate bipolar transistor T43 and a collector of the insulated-gate bipolar transistor T44 to each other is used as one polarity terminal 4451 of the polarity module 445. A node N42 formed by connecting an emitter of the insulated-gate bipolar transistor T45 and a collector of the insulated-gate bipolar transistor T46 to each other is used as the other polarity terminal 4452 of the polarity module 445.

When the diagonal insulated-gate bipolar transistors T43 and T46 are controlled to be on and the insulated-gate bipolar transistors T44 and T45 are controlled to be off, the polarity terminals 4451 and 4452 are respectively used a positive polarity output terminal and a negative polarity output terminal. A current flows out of the polarity terminal 4451, and flows into the polarity terminal 4452. When the other diagonal insulated-gate bipolar transistors T44 and T45 are controlled to be on and the insulated-gate bipolar transistors T43 and T46 are controlled to be off, the polarity terminals 4451 and 4452 are respectively used a negative polarity output terminal and a positive polarity output terminal. A current flows out of the polarity terminal 4452, and flows into the polarity terminal 4451.

FIG. 9 is a specific circuit diagram of an output module in a hybrid DC circuit breaker according to a third embodiment of the present invention. As shown in FIG. 9, an output module 446 is a coreless transformer, and includes a primary winding L41 and a secondary winding L42. A dotted terminal and an opposite-polarity terminal of the primary winding L41 are respectively used to be connected to the positive polarity output terminal and the negative polarity output terminal of the rectifying circuit 244 or connected to the two polarity terminals 2451 and 2452 of the polarity module 245. A dotted terminal and an opposite-polarity terminal of the secondary winding L42 are respectively used as output terminals 4461 and 4462, and are respectively used to be connected to a semiconductor switch and a mechanical switch. When a current flows from the opposite-polarity terminal of the primary winding L41 to the dotted terminal, a current in the secondary winding L42 flows from the output terminal 4461 to the output terminal 4462. The coreless transformer 446 has a galvanic isolation function, and can also decrease power consumption caused by transmission of a high-frequency resonance current $I_{RES}$.

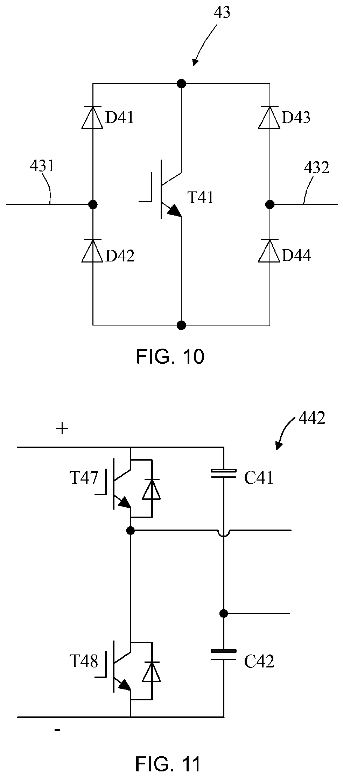

FIG. 10 is a specific circuit diagram of a semiconductor switch in a hybrid DC circuit breaker according to a fourth embodiment of the present invention. As shown in FIG. 10, a semiconductor switch 43 includes a bridge circuit formed by connecting four diodes D41, D42, D43, and D44, and an insulated-gate bipolar transistor T41 having a collector connected to negative electrodes of the diodes D41 and D43 and an emitter connected to positive electrodes of the diodes D42 and D44. When the insulated-gate bipolar transistor T41 is controlled to be on, in one conductive path, a current flows in via a terminal 431, runs through the diode D41, the insulated-gate bipolar transistor T41 that is on, and the diode D44, and flows to a terminal 432; in the other conductive path, a current flows in via the terminal 432, runs through the diode D43, the insulated-gate bipolar transistor T41 that is on, and the diode D42, and flows to the terminal 431.

FIG. 11 is a specific circuit diagram of an inverter in a hybrid DC circuit breaker according to a fifth embodiment of the present invention. As shown in FIG. 11, an inverter 442 is a half-bridge inverter, and includes insulated-gate bipolar transistors T47 and T48 and capacitors C41 and C42. A positive polarity input terminal and a negative polarity input terminal of the half-bridge inverter 442 are respectively electrically connected to a positive electrode and a negative electrode of the DC power source 241, and the half-bridge inverter 442 is used to invert a direct current outputted by the DC power source 241 into an alternating current. The half-bridge inverter 442 has only two switching transistors, thereby reducing device costs.

In other embodiments of the present invention, the inverter may also be a single-level, two-level, or multi-level full bridge (H-bridge) inverter.

In another embodiment of the present invention, a switching transistor such as a metal-oxide-semiconductor field-effect transistor (MOSFET) may be used in place of the insulated-gate bipolar transistor in the semiconductor switch 33 and/or the polarity module 345 in the aforementioned embodiments.

In another embodiment of the present invention, a hybrid DC circuit breaker may include a plurality of semiconductor switches 33 connected in series to each other.

In another embodiment of the present invention, the rectifying circuit 244 may be a half-wave rectifying circuit, so as to rectify an alternating current into a pulsating direct current.

Although the present invention has been described through preferred embodiments, the present invention is not limited to the embodiments described herein, but includes various changes and variations made without departing from the scope of the present invention as it is defined in the appended claims.

**Claims**

**1.**    A hybrid DC circuit breaker (1), comprising:

a mechanical switch (11, 21, 31) connected on a first current branch; and
a semiconductor switch (13, 23, 33, 43) and a forced resonance injection circuit (14, 24) connected on a second current branch, the forced resonance injection circuit (14, 24) comprising a first terminal and a second terminal, the first terminal of the forced resonance injection circuit (14, 24) being connected to one end of the semiconductor switch (13, 23, 33, 43), and the second terminal of the forced resonance injection circuit (14, 24) and the other end of the semiconductor switch (13, 23, 33, 43) being connected to two ends of the mechanical switch;
wherein the hybrid DC circuit breaker (1) is configured such that it is possible to control the semiconductor switch (13, 23, 33, 43) to be on, when the mechanical switch (11, 21, 31) is in a process of switching off, and at the same time to control the forced resonance injection circuit (14, 24) to inject to the mechanical switch (11, 21, 31) a gradually increasing injection current in a direction opposite to that of a current in the mechanical switch (11, 21, 31), so that the current in the mechanical switch (11, 21, 31) gradually decreases to zero within a predetermined diverting time, and the current is diverted from the first current branch to the second current branch;
**characterized in that**
the forced resonance injection circuit (14, 24) comprises:

a DC power source (241, 341), powered by a DC voltage on the first current branch or an external power source, so as to charge a DC bus capacitor (C1);
a DC bus, connected to the DC bus capacitor (C1), and used to provide a current to the forced resonance injection circuit (14, 24);
an inverter (242, 342, 442), provided with switching pulses during current injection so as to produce periodic square-wave voltage pulses having alternating polarities;
a resonance circuit (243, 343), comprising an inductor and a capacitor connected in series to each other, having one end connected to an output end of the inverter, and having the other end used to output an alternating current having gradually increasing amplitude;
a rectifying circuit (244, 344), having an input end connected to the other end of the resonance circuit (243), and having an output end used to output a pulsating direct current having gradually increasing amplitude, and

an output module (246, 346, 446), having an input end electrically connected to the output end of the rectifying circuit (244, 344), and having an output end used as the first terminal and the second terminal of the forced resonance injection circuit (14, 24), the output module being used to filter and amplify the pulsating direct current, and output the injection current;

wherein an equivalent resistor, an equivalent capacitor, and an equivalent inductor of the inverter (242, 342, 442), the resonance circuit (243, 343), the rectifying circuit (244, 344) and the output module (246, 346, 446) form an underdamped resonance circuit; and

a frequency of the periodic square-wave voltage pulses depends on a resonance frequency of the underdamped resonance circuit.

2. The hybrid DC circuit breaker (1) according to claim 1, wherein the hybrid DC circuit breaker (1) is configured such that it is possible to control the forced resonance injection circuit (14, 24) to stop outputting the injection current, when the current in the mechanical switch (11, 21, 31) decreases to zero within the predetermined diverting time.

3. The hybrid DC circuit breaker (1) according to claim 2, wherein the hybrid DC circuit breaker (1) is configured such that it is possible to control the semiconductor switch (13, 23, 33, 43) to be off, when a contact pitch of the mechanical switch (11, 21, 31) reaches a predetermined threshold.

4. The hybrid DC circuit breaker (1) according to claim 1, wherein

the semiconductor switch (13, 23, 33, 43) is a bidirectionally controllable semiconductor switch;

the hybrid DC circuit breaker (1) further comprises a polarity module (245, 345, 445) connected between the rectifying circuit (244, 344) and the output module (246, 346, 446), and the polarity module (245, 345, 445) comprises a full-bridge circuit controlled to change polarities of an input current and an output current of the polarity module (245, 345, 445)

wherein the equivalent resistor, the equivalent capacitor, and the equivalent inductor of the inverter (242, 342, 442), the resonance circuit (243), the rectifying circuit (244, 344), the polarity module (245, 345, 445) and the output module (246, 346, 446) form the underdamped resonance circuit.

5. The hybrid DC circuit breaker (1) according to claim 1, wherein the inverter (242, 342, 442) is a single-level, two-level, or multi-level full-bridge inverter or half-bridge inverter.

6. The hybrid DC circuit breaker (1) according to claim 1, wherein the output module (246, 346, 446) is configured to be a transformer to produce a current disconnection between the input end thereof and the first current branch.

7. The hybrid DC circuit breaker (1) according to claim 1, wherein the output module (346) is an autotransformer comprising a first winding and a second winding, a first terminal of the first winding being electrically connected to a first output terminal of the rectifying circuit (244, 344), a second terminal of the first winding being electrically connected to a first terminal of the second winding, and being used as a first output terminal of the forced resonance injection circuit (14, 24), and a second terminal of the second winding being electrically connected to a second output terminal of the rectifying circuit (244, 344), and being used as a second output terminal of the forced resonance injection circuit (14, 24).

8. The hybrid DC circuit breaker (1) according to claim 6 or 7, wherein the transformer or the autotransformer is coreless.

9. The hybrid DC circuit breaker (1) according to claim 4, wherein the polarity module (445) comprises:

a first switching transistor and a second switching transistor connected to form a first bridge arm, a first node formed by connecting the first switching transistor and the second switching transistor to each other being used as the first polarity terminal; and

a third switching transistor and a fourth switching transistor connected to form a second bridge arm, a second node formed by connecting the third switching transistor and the fourth switching transistor to each other being used as the second polarity terminal;

wherein a first electrode of the first switching transistor and a first electrode of the third switching transistor are connected to a positive polarity output terminal of the rectifying circuit (244, 344), and a second electrode of the second switching transistor and a second electrode of the fourth switching transistor are connected to a negative polarity output terminal of the rectifying circuit (244, 344).

10. The hybrid DC circuit breaker (1) according to any one of claims 1 to 3, wherein the hybrid DC circuit breaker (1) further comprises a surge arrester (12)

connected in parallel to the semiconductor switch (13, 23, 33, 43).

## Patentansprüche

1. Hybrider Gleichstromschutzschalter (1), umfassend:

   einen mechanischen Schalter (11, 21, 31), der an einen ersten Stromzweig angeschlossen ist; und

   einen Halbleiterschalter (13, 23, 33, 43) und eine Zwangsresonanz-Injektionsschaltung (14, 24), die an einen zweiten Stromzweig angeschlossen sind, wobei die Zwangsresonanz-Injektionsschaltung (14, 24) einen ersten Anschluss und einen zweiten Anschluss umfasst, wobei der erste Anschluss der Zwangsresonanz-Injektionsschaltung (14, 24) mit einem Ende des Halbleiterschalters (13, 23, 33, 43) verbunden ist und der zweite Anschluss der Zwangsresonanz-Injektionsschaltung (14, 24) und das andere Ende des Halbleiterschalters (13, 23, 33, 43) mit zwei Enden des mechanischen Schalters verbunden sind;

   wobei der hybride Gleichstromschutzschalter (1) so konfiguriert ist, dass es möglich ist, den Halbleiterschalter (13, 23, 33, 43) so zu steuern, dass er eingeschaltet ist, wenn der mechanische Schalter (11, 21, 31) gerade ausgeschaltet wird, und gleichzeitig die Zwangsresonanz-Injektionsschaltung (14, 24) so zu steuern, dass sie in den mechanischen Schalter (11, 21, 31) einen allmählich ansteigenden Injektionsstrom in einer Richtung injiziert, die der eines Stroms in dem mechanischen Schalter (11, 21, 31) entgegengesetzt ist, sodass der Strom im mechanischen Schalter (11, 21, 31) innerhalb einer vorgegebenen Umleitungszeit allmählich auf null verringert wird und der Strom vom ersten Stromzweig zum zweiten Stromzweig umgeleitet wird; **dadurch gekennzeichnet, dass** die Zwangsresonanz-Einspeiseschaltung (14, 24) Folgendes umfasst:

   eine Gleichstromquelle (241, 341), die durch eine Gleichspannung auf dem ersten Stromzweig oder eine externe Stromquelle gespeist wird, um einen Gleichstrom-Buskondensator (C1) aufzuladen;
   einen Gleichstrombus, der mit dem Gleichstrombuskondensator (C1) verbunden ist und verwendet wird, um einen Strom für die Zwangsresonanz-Injektionsschaltung (14, 24) bereitzustellen;
   einen Wechselrichter (242, 342, 442), der während der Strominjektion mit Schaltimpulsen bereitgestellt wird, um periodische Rechteckimpulse mit abwechselnden Polaritäten zu erzeugen;
   eine Resonanzschaltung (243, 343), umfassend einen Induktor und einen Kondensator, die in Reihe miteinander verbunden sind, wobei ein Ende mit einem Ausgangsende des Wechselrichters verbunden ist und das andere Ende verwendet wird, um einen Wechselstrom mit allmählich zunehmender Amplitude auszugeben;
   eine Gleichrichterschaltung (244, 344), die ein Eingangsende aufweist, das mit dem anderen Ende der Resonanzschaltung (243) verbunden ist, und ein Ausgangsende aufweist, das verwendet wird, um einen pulsierenden Gleichstrom mit allmählich zunehmender Amplitude auszugeben, und
   ein Ausgangsmodul (246, 346, 446), das ein Eingangsende aufweist, das elektrisch mit dem Ausgangsende der Gleichrichterschaltung (244, 344) verbunden ist, und ein Ausgangsende aufweist, das als erster Anschluss und zweiter Anschluss der Zwangsresonanz-Injektionsschaltung (14, 24) verwendet wird, wobei das Ausgangsmodul verwendet wird, um den pulsierenden Gleichstrom zu filtern und zu verstärken und den Injektionsstrom auszugeben;
   wobei ein äquivalenter Widerstand, ein äquivalenter Kondensator und ein äquivalenter Induktor des Wechselrichters (242, 342, 442), der Resonanzschaltung (243, 343), der Gleichrichterschaltung (244, 344) und des Ausgangsmoduls (246, 346, 446) eine unterdämpfte Resonanzschaltung bilden und
   eine Frequenz der periodischen Rechteck-Spannungsimpulse von einer Resonanzfrequenz der unterdämpften Resonanzschaltung abhängt.

2. Hybrider Gleichstromschutzschalter (1) nach Anspruch 1, wobei der hybride Gleichstromschutzschalter (1) so konfiguriert ist, dass es möglich ist, die Zwangsresonanz-Injektionsschaltung (14, 24) so zu steuern, dass sie die Ausgabe des Injektionsstroms stoppt, wenn der Strom im mechanischen Schalter (11, 21, 31) innerhalb der vorgegebenen Umleitungszeit auf null verringert wird.

3. Hybrider Gleichstromschutzschalter (1) nach Anspruch 2, wobei der hybride Gleichstromschutzschalter (1) so konfiguriert ist, dass es möglich ist, den Halbleiterschalter (13, 23, 33, 43) so zu steuern, dass er ausgeschaltet ist, wenn ein Kontaktabstand des mechanischen Schalters (11, 21, 31) einen vorbestimmten Schwellenwert erreicht.

**4.** Hybrider Gleichstromschutzschalter (1) nach Anspruch 1, wobei

der Halbleiterschalter (13, 23, 33, 43) ein bidirektional steuerbarer Halbleiterschalter ist;
der hybride Gleichstromschutzschalter (1) weiter ein Polaritätsmodul (245, 345, 445) umfasst, das zwischen der Gleichrichterschaltung (244, 344) und dem Ausgangsmodul (246, 346, 446) angeschlossen ist, und das Polaritätsmodul (245, 345, 445) eine Vollbrückenschaltung umfasst, die zur Veränderung der Polaritäten eines Eingangsstroms und eines Ausgangsstroms des Polaritätsmoduls (245, 345, 445) gesteuert wird,
wobei ein äquivalenter Widerstand, ein äquivalenter Kondensator und ein äquivalenter Induktor des Wechselrichters (242, 342, 442), der Resonanzschaltung (243, 343), der Gleichrichterschaltung (244, 344), des Polaritätsmoduls (245, 345, 445) und des Ausgangsmoduls (246, 346, 446) die unterdämpfte Resonanzschaltung bilden.

**5.** Hybrider Gleichstromschutzschalter (1) nach Anspruch 1, wobei der Wechselrichter (242, 342, 442) ein einstufiger, zweistufiger oder mehrstufiger Vollbrücken-Wechselrichter oder Halbbrücken-Wechselrichter ist.

**6.** Hybrider Gleichstromschutzschalter (1) nach Anspruch 1, wobei das Ausgangsmodul (246, 346, 446) als Transformator konfiguriert ist, um eine Stromtrennung zwischen seinem Eingangsende und dem ersten Stromzweig zu erzeugen.

**7.** Hybrider Gleichstromschutzschalter (1) nach Anspruch 1, wobei das Ausgangsmodul (346) ein Spartransformator ist, umfassend eine erste Wicklung und eine zweite Wicklung, wobei ein erster Anschluss der ersten Wicklung elektrisch mit einem ersten Ausgangsanschluss der Gleichrichterschaltung (244, 344) verbunden ist, ein zweiter Anschluss der ersten Wicklung elektrisch mit einem ersten Anschluss der zweiten Wicklung verbunden ist und als erster Ausgangsanschluss der Zwangsresonanz-Injektionsschaltung (14, 24) verwendet wird, und ein zweiter Anschluss der zweiten Wicklung elektrisch mit einem zweiten Ausgangsanschluss der Gleichrichterschaltung (244, 344) verbunden ist und als zweiter Ausgangsanschluss der Zwangsresonanz-Injektionsschaltung (14, 24) verwendet wird.

**8.** Hybrider Gleichstromschutzschalter (1) nach Anspruch 6 oder 7, wobei der Transformator oder der Spartransformator kernlos ist.

**9.** Hybrider Gleichstromschutzschalter (1) nach Anspruch 4, wobei das Polaritätsmodul (445) Folgendes umfasst:

einen ersten Schalttransistor und einen zweiten Schalttransistor, die verbunden sind, um einen ersten Brückenarm zu bilden, wobei ein erster Knoten, der durch Verbinden des ersten Schalttransistors und des zweiten Schalttransistors miteinander gebildet wird, als der erste Polaritätsanschluss verwendet wird; und
einen dritten Schalttransistor und einen vierten Schalttransistor, die verbunden sind, um einen zweiten Brückenarm zu bilden, wobei ein zweiter Knoten, der durch Verbinden des dritten Schalttransistors und des vierten Schalttransistors miteinander gebildet wird, als der zweite Polaritätsanschluss verwendet wird;
wobei eine erste Elektrode des ersten Schalttransistors und eine erste Elektrode des dritten Schalttransistors mit einem Ausgangsanschluss positiver Polarität der Gleichrichterschaltung (244, 344) verbunden sind und eine zweite Elektrode des zweiten Schalttransistors und eine zweite Elektrode des vierten Schalttransistors mit einem Ausgangsanschluss negativer Polarität der Gleichrichterschaltung (244, 344) verbunden sind.

**10.** Hybrider Gleichstromschutzschalter (1) nach einem der Ansprüche 1 bis 3, wobei der hybride Gleichstromschutzschalter (1) weiter einen Überspannungsableiter (12) umfasst, der parallel zu dem Halbleiterschalter (13, 23, 33, 43) geschaltet ist.

## Revendications

**1.** Disjoncteur de circuit à courant continu (1) hybride, comprenant :

un commutateur (11, 21, 31) mécanique connecté sur une première branche de courant ; et
un commutateur à semi-conducteur (13, 23, 33, 43) et un circuit d'injection à résonance forcée (14, 24) connectés sur une seconde branche de courant, le circuit d'injection à résonance forcée (14, 24) comprenant une première borne et une seconde borne, la première borne du circuit d'injection à résonance forcée (14, 24) étant connectée à une extrémité du commutateur à semi-conducteur (13, 23, 33, 43), et la seconde borne du circuit d'injection à résonance forcée (14, 24) et l'autre extrémité du commutateur à semi-conducteur (13, 23, 33, 43) étant connectées à deux extrémités du commutateur mécanique ;
le disjoncteur de circuit à courant continu (1) étant conçu de telle sorte qu'il est possible d'amener le commutateur à semi-conducteur (13, 23, 33, 43) à être sous tension lorsque le commutateur (11, 21, 31) mécanique est en cours de processus de mise hors tension, et en même temps d'amener le circuit d'injection à résonance forcée (14, 24) à injecter dans le commutateur (11, 21, 31) mécanique un courant d'injection augmentant progressivement dans une direction opposée à celle du courant dans le commutateur (11, 21, 31) mécanique de telle sorte que le courant dans le commutateur (11, 21, 31) mécanique diminue progressivement jusqu'à zéro dans un temps de dérivation prédéterminé, et le courant est dévié de la première branche de courant vers la seconde branche de courant ;

**caractérisé en ce que**

le circuit d'injection à résonance forcée (14, 24) comprend :

une source d'alimentation en courant continu (241, 341), alimentée par une tension à courant continu sur la première branche de courant ou une source d'alimentation externe, de manière à charger un condensateur de bus à courant continu (C1) ;

un bus à courant continu, connecté au condensateur de bus à courant continu (C1), et utilisé pour fournir un courant au circuit d'injection à résonance forcée (14, 24) ;

un onduleur (242, 342, 442), doté des impulsions de commutation lors de l'injection de courant de manière à générer des impulsions de tension périodiques à onde carrée présentant des polarités alternées ;

un circuit de résonance (243, 343), comprenant un inducteur et un condensateur connectés en série l'un à l'autre, comportant une extrémité connectée à une extrémité de sortie de l'onduleur, et comportant une autre extrémité utilisée pour produire un courant alternatif présentant une amplitude augmentant progressivement ;

un circuit redresseur (244, 344), comportant une extrémité d'entrée connectée à l'autre extrémité du circuit de résonance (243), et comportant une extrémité de sortie utilisée pour produire un courant continu pulsé présentant une amplitude augmentant progressivement, et

un module de sortie (246, 346, 446), comportant une extrémité d'entrée connectée électriquement à l'extrémité de sortie du circuit de redressement (244, 344), et comportant une extrémité de sortie utilisé comme première borne et seconde borne du circuit d'injection à résonance forcée (14, 24), le module de sortie étant utilisé pour filtrer et amplifier le courant continu pulsé, et pour produire le courant d'injection ;

dans lequel une résistance équivalente, un condensateur équivalent et un inducteur équivalent de l'onduleur (242, 342, 442), du circuit de résonance (243, 343), du circuit de redressement (244, 344) et du module de sortie (246, 346, 446) forment un circuit de résonance sous-amorti, et la fréquence des impulsions de tension périodiques à onde carrée dépend de la fréquence de résonance du circuit de résonance sous-amorti.

2. Disjoncteur de circuit à courant continu (1) hybride selon la revendication 1, le disjoncteur de circuit à courant continu (1) étant conçu de telle sorte qu'il est possible d'amener le circuit d'injection à résonance forcée (14, 24) à arrêter la production du courant d'injection lorsque le courant dans le commutateur (11, 21, 31) mécanique diminue jusqu'à zéro dans le temps de dérivation prédéterminé.

3. Disjoncteur de circuit à courant continu (1) hybride selon la revendication 2, le disjoncteur de circuit à courant continu (1) étant conçu de telle sorte qu'il est possible d'amener le commutateur à semi-conducteur (13, 23, 33, 43) à être mis hors tension lorsqu'un pas de contact du commutateur (11, 21, 31) mécanique atteint un seuil prédéterminé.

4. Disjoncteur de circuit à courant continu (1) hybride selon la revendication 1, dans lequel

le commutateur à semi-conducteur (13, 23, 33, 43) est un commutateur à semi-conducteur à commande bidirectionnelle ;

le disjoncteur de circuit à courant continu (1) hybride comprend en outre un module de polarité (245, 345, 445) connecté entre le circuit de redressement (244, 344) et le module de sortie (246, 346, 446), et le module de polarité (245, 345, 445) comprend un circuit en pont complet commandé pour changer les polarités d'un courant d'entrée et d'un courant de sortie du module de polarité (245, 345, 445),

dans lequel la résistance équivalente, le condensateur équivalent et l'inducteur équivalent de l'onduleur (242, 342, 442), du circuit de résonance (243, 343), du circuit de redressement (244, 344), du module de polarité (245, 345, 445) et du module de sortie (246, 346, 446) forment le circuit de résonance sous-amorti.

5. Disjoncteur de circuit à courant continu (1) hybride selon la revendication 1, dans lequel l'onduleur (242, 342, 442) est un onduleur à pont complet ou à demi-pont à un seul niveau, à deux niveaux ou à plusieurs niveaux.

6. Disjoncteur de circuit à courant continu (1) hybride selon la revendication 1, dans lequel le module de sortie (246, 346, 446) est conçu pour être un transformateur pour provoquer une déconnexion de courant entre son extrémité d'entrée et la première branche de courant.

7. Disjoncteur de circuit à courant continu (1) hybride selon la revendication 1, dans lequel le module de sortie (346) est un autotransformateur comprenant un premier enroulement et un second enroulement, une première borne du premier enroulement étant connectée électriquement à une première borne de sortie du circuit de redressement (244, 344), une seconde borne du premier enroulement étant connectée électriquement à une première borne du second enroulement, et étant utilisée comme première borne de sortie du circuit d'injection à résonance forcée (14, 24), et une seconde borne du second enroulement étant connectée électriquement à une seconde borne de sortie du circuit de redressement (244, 344), et étant utilisée comme seconde borne de sortie du circuit d'injection à résonance forcée (14, 24).

8. Disjoncteur de circuit à courant continu (1) hybride selon la revendication 6 ou 7, dans lequel le transformateur ou l'autotransformateur est sans noyau.

9. Disjoncteur de circuit à courant continu (1) hybride selon la revendication 4, dans lequel le module de polarité (445) comprend :

un premier transistor de commutation et un deuxième transistor de commutation connectés pour former un premier bras de pont, un premier nœud, formé par connexion du premier transistor de commutation et du deuxième transistor de commutation l'un à l'autre, étant utilisé comme première borne de polarité ; et
un troisième transistor de commutation et un quatrième transistor de commutation connectés pour former un second bras de pont, un second nœud, formé par connexion du troisième transistor de commutation et du quatrième transistor de commutation l'un à l'autre, étant utilisé comme seconde borne de polarité ;
dans lequel une première électrode du premier transistor de commutation et une première électrode du troisième transistor de commutation sont connectées à une borne de sortie de polarité positive du circuit de redressement (244, 344), et une seconde électrode du deuxième transistor de commutation et une seconde électrode du quatrième transistor de commutation sont connectées à une borne de sortie de polarité négative du circuit de redressement (244, 344).

10. Disjoncteur de circuit à courant continu (1) hybride selon l'une quelconque des revendications 1 à 3, dans lequel le disjoncteur de circuit à courant continu (1) comprend en outre un parafoudre (12) connecté en parallèle au commutateur à semi-conducteur (13, 23, 33, 43).

FIG. 1

FIG. 2

FIG. 3

FIG. 4

FIG. 5

FIG. 6

FIG. 7

445

T43    T45

4451

N41    N42

4452

T44    T46

-

**FIG. 8**

446    4461

M

L41    L42

4462

**FIG. 9**

43

D41  D43

431  T41  432

D42  D44

FIG. 10

442

+

T47  C41

C42

T48

-

FIG. 11

**EP 4 036 949 B1**

**REFERENCES CITED IN THE DESCRIPTION**

**Patent documents cited in the description**

- JP 2001067969 A